Europäisches Patentamt

**European Patent Office**

Office européen des brevets

(19)

(11) Veröffentlichungsnummer : **0 024 549**
**B1**

# (12) EUROPÄISCHE PATENTSCHRIFT

(45) Veröffentlichungstag der Patentschrift :
17.10.84

(21) Anmeldenummer : 80104355.5

(22) Anmeldetag : 24.07.80

(51) Int. Cl.³ : **H 03 K 19/094, H 03 K 5/00**

(54) **TTL-Pegelumsetzer zur Ansteuerung von Feldeffekttransistoren.**

(30) Priorität : 01.09.79 DE 2935465

(43) Veröffentlichungstag der Anmeldung :
11.03.81 Patentblatt 81/10

(45) Bekanntmachung des Hinweises auf die Patenterteilung : 17.10.84 Patentblatt 84/42

(84) Benannte Vertragsstaaten :
**DE FR GB**

(56) Entgegenhaltungen :
**DE-A- 2 243 671**
**US-A- 3 708 689**
**US-A- 3 710 271**
**US-A- 4 023 050**
**IEEE JOURNAL OF SOLID-STATE CIRCUITS, Band SC-13, Nr. 3, Juni 1978, New York E. ARAI et al. "A 64-kbit Dynamic MOS RAM" Seiten 333 bis 338**

(73) Patentinhaber : **International Business Machines Corporation**
**Old Orchard Road**
**Armonk, N.Y. 10504 (US)**

(72) Erfinder : **Clemen, Rainer**
**Maurener Weg 133**
**D-7030 Böblingen (DE)**
Erfinder : **Fischer, Walter**
**Brombergstrasse 16**
**D-7033 Herrenberg (DE)**
Erfinder : **Haug, Werner**
**Pontoiser Strasse 43**
**D-7030 Böblingen (DE)**

(74) Vertreter : **Neuland, Johannes, Dipl.-Ing.**
**Schönaicher Strasse 220**
**D-7030 Böblingen (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf einen TTL-Pegelumsetzer zur Ansteuerung von Feldeffekttransistoren.

In modernen programmgesteuerten Datenverarbeitungsanlagen werden als Hauptspeicher zunehmend monolithisch integrierte Halbleiterspeicher verwendet, die zur Minimierung von Platzbedarf und Verlustleistung vorzugsweise mit Feldeffekttransistoren, im folgenden kurz als FET bezeichnet, realisiert sind. Die Ansteuerung derartiger Hauptspeicher erfolgt jedoch häufig durch logische Schaltungen, die aus bipolaren Transistoren aufgebaut sind, weil deren Schaltgeschwindigkeit größer ist. An den Nahtstellen zwischen bipolaren und FET-Schaltungen ergibt sich dabei stets das Problem der Pegelumwandlung.

Ein für digitale Schaltungen mit Bipolartransistoren typisches Spannungspegelschema ist das sog. TTL-Pegelschema. Dabei ist vereinbart, daß der eine Binärzustand, z. B. die logische « Null », durch einen Spannungswert im Bereich von 0 bis 0,8 Volt und der andere Binärzustand, z. B. die logische « Eins », durch einen Spannungswert im Bereich von 2,0 V bis zur maximalen Betriebsspannung von z. B. 5,5 V repräsentiert wird. Demgegenüber liegen der für FET-Schaltungen typische obere Ansteuerpegel sowie die Betriebsspannung deutlich höher, z. B. bei 8,5 V.

Durch die Veröffentlichung von E. ARAI und N. IEDA im Juniheft 1978 des IEEE Journal of Solid-State Circuits, Vol. SC-13, NO. 3, Seiten 333-338 ist aus Abschnitt IV auf den Seiten 335 und 336 in Verbindung mit der Fig. 5 eine Schaltung zum Umsetzen von TTL-Pegeln in FET-Pegel bekannt. Die in diesem bekannten Pegelumsetzer verwendeten Feldeffekttransistoren weisen eine Schwellenspannung VT von 0,8 V nominal auf, die nahe an dem Höchstwert von 0,8 V für den unteren TTL-Signalpegel liegt. Um zu verhindern, daß der Eingangs-FET leitet, wenn sich diesem ohnehin schon hohen Pegel noch Störimpulse überlagern, wird sein Source-Potential mit Hilfe eines Spannungsteilers angehoben. Der Eingangs-FET wird daher erst leitend, wenn das ihm zugeführte Signal größer als die Summe aus seiner Source-Vorspannung und seiner Schwellenspannung ist. Durch die genannte Maßnahme kann zwar der Einfluß von Störimpulsen auf das Schaltverhalten des Eingangs-FET beseitigt werden. Sie hat jedoch zur Folge, daß dieser FET jetzt erst ab einer Eingangssignalspannung von beispielsweise 1,5 V zu leiten beginnt. Dies bedeutet aber, daß der Eingangs-FET im ungünstigsten Fall mit nur 2,0 V für den oberen TTL-Signalpegel lediglich schwach leitet. Der genannte Nachteil läßt sich zwar durch Erhöhen des Mindestwertes für die dem oberen Signalpegel zugeordnete Spannung beseitigen, aber der Pegelumsetzer ist dann nicht mehr mit den üblichen TTL-Pegelgrenzwerten von 0,8 V und 2,0 V zu betreiben. Außerdem ist für eine einwandfreie Funktion der bekannten Schaltung eine konstante Schwellenspannung der verwendeten FET Voraussetzung. Erfahrungsgemäß ist die Schwellenspannung von FET jedoch weiten Fertigungstoleranzen unterworfen.

Die Erfindung, wie sie in den Ansprüchen gekennzeichnet ist, löst daher die Aufgabe, TTL-Pegel, insbesondere die Grenzwerte, mit Hilfe einer FET-Schaltung zu erkennen und umzusetzen, die auch bei unterschiedlichen Schwellenspannungen der FET betriebssicher arbeitet.

Im folgenden wird die Erfindung anhand von Zeichnungen näher erläutert, die lediglich einen Ausführungsweg der Erfindung darstellen. Von den Zeichnungen zeigen :

Figur 1 das Schaltbild eines Ausführungsbeispiels der Erfindung und

Figur 2 ein zugehöriges Impulsdiagramm zur Erläuterung der Arbeitsweise der Schaltung nach Fig. 1.

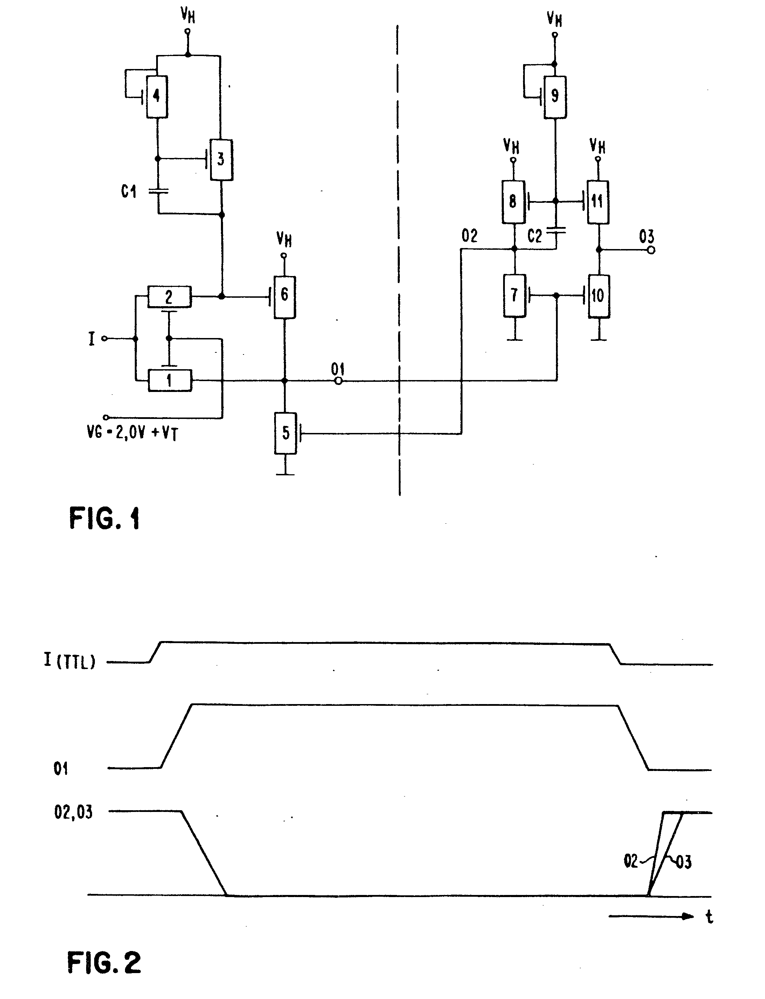

Bei dem in Fig. 1 wiedergegebenen Schaltbild des erfindungsgemäßen Pegelumsetzers ist die Verwendung üblicher N-Kanal MOS-Feldeffekttransistoren vorausgesetzt, deren Betriebsspannung VH in typischen Fällen etwa + 8,5 V beträgt. Die Erfindung kann jedoch in gleicher Weise mit Feldeffekttransistoren des anderen Leitungstyps und einer entsprechenden geänderten Betriebsspannung realisiert werden.

Das in Fig. 1 wiedergegebene Schaltbild des erfindungsgemäßen Pegelumsetzers zeigt in seinem rechts der gestrichelten Linie dargestellten Teil einen aus der DE-A-22 43 671 bekannten invertierenden FET-Leistungsverstärker. Es handelt sich dabei um einen verbesserten, sogenannten Bootstrap-Leistungsverstärker, bei dem der Bootstrap-Kondensator C2 in einer parallel zur Ausgangsstufe (FET 10 und 11) angeordneten gleichartigen Inverterstufe (FET 7 und 8) vorgesehen ist. Die Ansteuerung des bekannten Leistungsverstärkers erfolgt vom Ausgang 01 des erfindungsgemäßen Pegelumsetzers her, dessen Schaltbild im linken Teil der Fig. 1 dargestellt ist. Aufgrund seiner Konzeption weist dieser Pegelumsetzer eine hohe Unempfindlichkeit gegenüber Störimpulsen auf und arbeitet außerdem eingangsseitig schwellenspannungsunabhängig, wie im Verlauf der weiteren Beschreibung noch gezeigt wird.

Der erfindungsgemäße Pegelumsetzer besteht im wesentlichen aus einem als Übertragungs- bzw. Isolations-FET dienenden ersten Eingangs-FET 1, der zwischen dem Eingang I und dem Ausgang 01 des Pegelumsetzers angeordnet ist, sowie aus der Reihenschaltung aus einem ebenfalls als Übertragungs bzw. Isolations-FET dienenden zweiten Eingangs-FET 2 und einem als Last-FET 3 dienenden dritten FET. Die Reihenschaltung liegt zwischen dem Eingang I und dem nicht an das Bezugspotential angeschlossenen Pol VH der Betriebsspannung. Der gemeinsame Verbindungspunkt von Eingangs-FET 2 und Last-FET 3 ist an das Gate eines als Sourcefolger arbeitenden weiteren FET angeschlossen, der als Lade-FET 6 die Eingangskapazität des nachfolgenden invertierenden FET-Leistungsverstärkers auflädt, der im rechten Teil der Fig. 1 dargestellt ist. Die Gate-Elektroden der beiden Eingangs-FET 1 und 2 sind miteinander verbunden. Ihnen wird eine Referenzspannung VG zugeführt, die dem Mindestwert für den oberen TTL-Signalpegel von z. B. 2,0 V zuzüglich der Schwellenspannung VT, die für alle hier betrachteten FET gleich sein möge, entspricht. Die Erzeugung der Referenzspannung VG erfolgt in üblicher Weise durch eine auf demselben Halbleiterchip vorgesehene Spannungsteilerschaltung. Sie kann aus einem Lastelement und einer FET-Diode bestehen, längs der infolge kurzgeschlossener Gate- und Drain-Elektrode die Schwellenspannung VT abfällt und deren Sourcepotential durch einen ohmschen Spannungsteiler für die TTL-Betriebsspannung auf einen Wert eingestellt wird, der mit dem oberen TTL-Pegel, insbesondere mit dem Mindestwert von 2,0 V, im Gleichlauf ist. Die gemeinsame Source-Elektrode der beiden Eingangs-FET 1 und 2 stellt die Eingangsklemme I des Pegelumsetzers dar, der die umzusetzenden TTL-Signalpegel zugeführt werden. Die Drain-Elektrode des Lade-FET 6 ist mit dem positiven Pol VH der Betriebsspannungsquelle verbunden und seine Source-Elektrode bildet zusammen mit dem Verbindungspunkt des Eingangs-FET 1 und eines sourceseitig geerdeten Entlade-FET 5 den Ausgang 01 des Pegelumsetzers.

Die Arbeitsweise der Schaltung nach Fig. 1 ist folgende : Wenn am Eingang I des Pegelumsetzers der untere TTL-Signal-pegel von z. B. 0,8 V anliegt, sind die Eingangs-FET 1 und 2 leitend. Dann ist nämlich die gemeinsame Gate-Source-Spannung VGS, die den Schaltzustand dieser eingangsseitig parallel geschalteten Eingangs-FET bestimmt, größer als deren Schwellenspannung VT. Die treibende Spannung VGS-VT ergibt sich aus dem Gate-Potential VG, dem Source-Potential VS und der Schwellenspannung VT zu

$$VGS - VT = VG - VS - VT$$
$$= 2{,}0\ V + VT - 0{,}8\ V - VT$$
$$= 1{,}2\ V.$$

Die Gleichung läßt den Vorteil erkennen, daß die die Leitfähigkeit der Eingangs-FET 1 und 2 bestimmende effektive Gate-Source-Spannung VGS − VT nicht mehr von der Schwellenspannung VT abhängt, da diese in Zeile 2 der obigen Gleichung zweimal mit jeweils entgegengesetzten Vorzeichen erscheint und sich aufhebt. Die als Bootstrap-Lastelement bekannte Kombination aus den FET 3 und 4 sowie dem Bootstrap-Kondensator C1 bewirkt nun einen Strom über den eingeschalteten Eingangs-FET 2. Das Drain-Potential des Eingangs-FET 2 und somit das Gate-Potential des Lade-FET 6 stellt sich dabei nach Maßgabe der Spannungsteilung durch die Reihenschaltung aus dem Eingangs-FET 2 und dem Last-FET 3 ein, und zwar auf einen Wert, der nur wenig höher als der Eingangspegel von 0,8 V ist, aber sicher klein genug, damit der nachfolgende Lade-FET 6 sperrt. Ein sicheres Sperren des Lade-FET 6 wird außerdem dadurch erreicht, daß dessen Source-Elektrode als Wirkung des unten beschriebenen Spannungsteilers aus dem Eingangs-FET 1 und einem Entlade-FET 5, über den die Eingangskapazität des nachfolgenden FET-Leistungsverstärkers entladbar ist, allenfalls auf einen Wert von etwa 0,5 V absinkt, also keineswegs Massepotential erreicht. Der andere Eingangs-FET 1 überträgt den unteren Eingangspegel auf den Ausgang 01 des Pegelumsetzers. Falls der Ausgang 01 vorher aufgeladen war, wird er nun also so weit entladen, daß sich an den Ausgängen 02 und 03 des nachgeschalteten bekannten FET-Leistungsverstärkers das Potential VH einstellt. — Zur Unterstützung des Entladevorganges des Ausgangs 01 und damit zur Verbesserung der Schaltgeschwindigkeit des bekannten, invertierenden FET-Leistungsverstärkers ist zusätzlich zum Eingangs-FET 1 am Ausgang 01 des Pegelumsetzers noch der schon erwähnte Entlade-FET 5 vorgesehen, dessen Gate direkt von der Ausgangsspannung am Ausgang 02 oder 03 des bekannten invertierenden Leistungsverstärkers angesteuert wird. Sobald diese die Schwellenspannung überschreitet, beginnt der Entlade-FET 5 zu leiten und die Verringerung der Gate-Spannung für die Treiber-FET 7 und 10 zu beschleunigen. Dies bewirkt eine weitere Zunahme der Ausgangsspannung, die wiederum zu einer verstärkten Entladung des Ausgangs 01 führt. — Durch diese positive Rückkopplung wird erreicht, daß sich bei einem hohen unteren TTL-Eingangspegel von 0,8 V zuverlässig und rechtzeitig ein niedrigerer Pegel unterhalb der FET-Schwellenspannung am Ausgang 01 des Pegelumsetzers ergibt, deren unterer Grenzwert 0,5 V betragen kann.

Erscheint am Eingang I des Pegelumsetzers der obere TTL-Signalpegel von 2,0 V, so sperren die beiden Eingangs-FET 1 und 2, da ihre Gate-Source-Spannung VGS jetzt die Schwellenspannung VT nicht mehr überschreitet, und zwar gilt

$$VGS - VT = VG - VS - VT$$
$$= 2{,}0\ V + VT - 2{,}0\ V - VT$$
$$= 0.$$

Die somit vom Eingang isolierte Gate-Elektrode des Lade-FET 6 wird dann über das Bootstrap-Lastelement aus den FET 3 und 4 sowie dem Kondensator C1 rasch auf die Spannung VH aufgeladen. Während der als Sourcefolger arbeitende Lade-FET 6 also leitet, stellt sich am Ausgang 01 des Pegelumsetzers die Betriebsspannung VH, verringert um die Schwellenspannung VT des Lade-FET 6 ein. Der erfindungsgemäße Pegelumsetzer konvertiert also durch Zusammenwirken von gesperrtem Eingangs-FET 2, Last-FET 3 und Lade-FET 6 einen oberen TTL-Pegel von nur 2,0 V schnell in eine hohe Spannung VH − VT, die mit etwa 7 V deutlich über dem oberen Grenzwert der FET-Schwellenspannung VT von 1,5 V liegt. Die Eingangs-FET 7 und 10 des nachgeschalteten invertierenden FET-Leistungsverstärkers sind daher beide stark leitend, so daß sich an dessen Ausgängen 02 und 03 ein nur wenig gegenüber dem Massepotential erhöhtes Potential ausbildet. Da dieses Potential auf das Gate des Entlade-FET 5 rückgekoppelt wird, sperrt dieser FET. Damit erzeugt der erfindungsgemäße Pegelumsetzer aus den FET 1 bis 6 bei Anliegen des oberen TTL-Signalpegels keine Gleichstrom-Verlustleistung.

Durch die vorliegende Erfindung wird also eine leicht integrierbare FET-Schaltung geschaffen, die eine zuverlässige Umsetzung von TTL-Pegeln (≤ 0,8 V, ≥ 2,0 V) in FET-Pegel (ca. 0 V, 8,5 V) erlaubt, und zwar unabhängig davon, ob die Schwellenspannung der verwendeten FET niedrig, z. B. 0,5 V, oder hoch, z. B. 1,5 V, ist. Die Schaltung ist auch bezüglich der Eingangsströme TTL-Kompatibel, da bei Anlegen des unteren Pegels ein Strom aus ihr herausfließt, dessen Größe durch entsprechende Dimensionierung des Last-FET 3 und der Reihenschaltung aus Eingangs-FET 1 und Entlade-FET 5 festgelegt werden kann. Der Eingangsstrom für den oberen Pegel ist vernachlässigbar klein.

**Ansprüche**

1. TTL-Pegelumsetzer zur Ansteuerung von Feldeffekttransitoren (FET), dadurch gekennzeichnet, daß

a) ein als Übertragungs- bzw. Isolations-FET dienender erster Eingangs-FET (1) mit seiner Source-Drain-Strecke zwischen dem Eingang (I) und dem Ausgang (01) des Pegelumsetzers angeordnet ist,

b) ein ebenfalls als Übertragungs- bzw. Isolations-FET dienender zweiter Eingangs-FET (2) vorgesehen ist, dessen Source- und Gate-Elektroden mit den entsprechenden Elektroden des ersten Eingangs-FET (1) verbunden sind, während seine Source-Drain-Strecke mit einem als Last-FET (3) dienenden dritten FET in Reihe liegt und diese Reihenschaltung zwischen den nicht an das Bezugspotential angeschlossenen Pol (VH) der Betriebsspannungsquelle und den Eingang (I) des Pegelumsetzers geschaltet ist,

c) den miteinander verbundenen Gate-Elektroden der beiden Eingangs-FET (1, 2) eine Referenzspannung (VG) zugeführt wird, die dem um die FET-Schwellenspannung erhöhten Mindestwert für den oberen TTL-Pegel entspricht, und

d) der gemeinsame Verbindungspunkt von zweitem Eingangs-FET (2) und Last-FET (3) an die Gate-Elektrode eines weiteren, als Sourcefolger auf die Eingangskapazität einer nachfolgenden Schaltung arbeitenden Lade-FET (6) angeschlossen ist, dessen Drain-Elektrode direkt mit dem nicht an das Bezugspotential angeschlossenen Pol (VH) der Betriebsspannungsquelle verbunden ist und dessen Source-Elektrode an den Ausgang (01) des Pegelumsetzers angeschlossen ist.

2. Pegelumsetzer nach Anspruch 1, dadurch gekennzeichnet, daß die Verbindung der Drain-Elektrode des zweiten Eingangs-FET (2) mit dem nicht an das Bezugspotential angeschlossenen Pol (VH) der Betriebsspannungsquelle über eine als Lastelement dienende, an sich bekannte Kombination zweier FET (3, 4) und eines Bootstrap-Kondensators (C1) erfolgt, bei der die Reihenschaltung eines zu einem Zweipol verdrahteten FET (4) mit einem Bootstrap-Kondensator (C1) parallel zur Source-Drain-Strecke des Last-FET (3) angeordnet und der Verbindungspunkt der Reihenschaltung an dessen Gate angeschlossen ist.

3. Pegelumsetzer nach den Ansprüchen 1 oder 2, dadurch gekennzeichnet, daß an seinen Ausgang (01) die Source-Drain-Strecke eines zusätzlichen Entlade-FETs (5) angeschlossen ist.

4. Pegelumsetzer nach Anspruch 3, dadurch gekennzeichnet, daß die Gate-Spannung des Entlade-FET (5) vom Ausgang eines bekannten invertierenden Bootstrap-Vorverstärkers bezogen wird, der dem Ausgang (01) des Pegelumsetzers nachgeschaltet ist.

5. Pegelumsetzer nach Anspruch 3, dadurch gekennzeichnet, daß die Gate-Spannung für den Entlade-FET (5) vom ersten (02) oder zweiten (03) Ausgang eines bekannten, aus zwei parallelen Inverterstufen in Bootstrap-Technik bestehenden FET-Leistungsverstärkers bezogen wird, der dem Ausgang (01) des Pegelumsetzers nachgeschaltet ist.

**Claims**

1. TTL level converter for controlling field effecttransistors (FET), characterized in that

a) a first input FET (1) serving as a transmission or insulation FET is arranged with its source-drain path between the input (I) and the output (01) of the level converter,

b) a second input FET (2) equally serving as a transmission or isolation FET is provided whose source and gate electrodes are connected to the corresponding electrodes of the first input FET (1) while its source-drain path is arranged in series with a third FET serving as load FET (3), and that this series connection is arranged between that pole (VH) of the operating voltage source that is not connected to the reference potential, and the input (I) of the level converter,

c) to the interconnected gate electrodes of the two input FET's (1, 2) a reference voltage (VG) is applied which corresponds to the minimum value for the upper TTL level increased by the FET threshold voltage, and

d) the common point of connection of the second input FET (2) and load FET (3) is connected with the gate electrode of a further FET (6) operating as a source follower charging input capacity of a subsequent circuit, the drain electrode of said further FET being directly connected to that pole (VH) of the operating voltage source that is not connected to the reference potential, and whose source electrode is connected to the output (01) of the level converter.

2. Level converter as claimed in claim 1, characterized in that the connection of the drain electrode of the second input FET (2) with that pole (VH) of the operating voltage source that is not connected to the reference potential, is effected via a combination known per se of two FET's (3, 4) serving as a load element, and of a bootstrap capacitor (C1) where the series connection of an FET (4) wired as a two-terminal element, and the bootstrap capacitor (C1) is arranged in parallel to the source-drain path of the load FET (3), and where the junction of the series connection is connected with its gate.

3. Level converter as claimed in any one of claims 1 or 2, characterized in that at its output (01) the source-drain path of an additional discharge FET (5) is provided.

4. Level converter as claimed in claim 3, characterized in that the gate voltage of the discharge FET (5) is obtained from the output of a known inverting bootstrap preamplifier that is arranged following the output (01) of the level converter.

5. Level converter as claimed in claim 3, characterized in that the gate voltage for the discharge FET (5) is obtained from the first (02) or second (03) output of a known FET power amplifier consisting of two parallel inverter stages in bootstrap technique, that is arranged following the output (01) of the level converter.

**Revendications**

1. Convertisseur de niveaux TTL pour la commande de transistors à effet de champ (FET), caractérisé par le fait que :

a) un premier FET d'entrée (1) servant de FET de transmission ou d'isolation est disposé, par sa voie source-drain, entre l'entrée (I) et la sortie (01) du convertisseur de niveau,

b) il est prévu un second FET d'entrée (2) servant également de FET de transmission ou d'isolation et dont les électrodes de source et de grille sont reliées aux électrodes correspondantes du premier FET d'entrée (1), tandis que sa voie source-drain est branchée en série avec un troisième FET servant de FET de charge (3) et que ce circuit série est branché entre le pôle (VH) de la source de tension de service, non raccordé au potentiel de référence, et l'entrée (I) du convertisseur de niveau,

c) qu'aux électrodes de grille reliées entre elles, des deux FET d'entrée (1, 2) est envoyée une tension de référence (VG) qui correspond à la valeur minimale, accrue de la tension de seuil des FET, pour le niveau haut TTL, et

d) que le point de liaison commun du second FET d'entrée (2) et du FET de charge (3) est raccordé à l'électrode de grille d'un autre FET de charge (6) agissant en tant que source suiveuse sur la capacité d'entrée d'un circuit branché en aval, et dont l'électrode de drain est reliée directement au pôle (VH) de la source de tension de service, non raccordé au potentiel de référence, et dont l'électrode de source est raccordée à la sortie (01) du convertisseur de niveau.

2. Convertisseur de niveau selon la revendication 1, caractérisé par le fait que la liaison de l'électrode de drain du second FET (2) au pôle (VH) de la source de tension de service, non raccordé au potentiel de référence, est réalisée par l'intermédiaire d'une combinaison connue en soi, servant d'élément de charge, de deux FET (3, 4) et d'un condensateur Bootstrap (C1), dans laquelle le circuit série d'un FET (4), câblé à la manière d'un dipôle et d'un condensateur Bootstrap (C1) est monté en parallèle avec la voie source-drain du FET de charge (3) et le point de liaison du circuit série est raccordé à la grille de ce FET.

3. Convertisseur de niveau selon la revendication 1 ou 2, caractérisé par le fait que la voie source-drain d'un FET de décharge (5) supplémentaire est raccordée à la sortie (01) du convertisseur.

4. Convertisseur de niveau selon la revendication 3, caractérisé par le fait que la tension de grille du FET de décharge (5) est tirée de la sortie d'un préamplificateur Bootstrap inverseur connu qui est branché en aval de la sortie (01) du convertisseur de niveau.

5. Convertisseur de niveau selon la revendication 3, caractérisé par le fait que la tension de grille pour le FET de décharge (5) est tirée de la première sortie (02) ou de la seconde sortie (03) d'un amplificateur de puissance à FET connu constitué selon la technique Bootstrap par deux étages inverseurs parallèles et qui est branché en aval de la sortie (01) du convertisseur de niveau.

**FIG. 1**

**FIG. 2**